# EUROPÄISCHE PATENTSCHRIFT

(11) **EP 0 890 220 B1**
(45) Veröffentlichungstag und Bekanntmachung des Hinweises auf die Patenterteilung: **11.07.2001**
(21) Anmeldenummer: 97919274.7
(22) Anmeldetag: 13.03.1997
(51) Int. Cl.: H03K 17/785

(54) **ELEKTRONISCHES ABZWEIGSCHALTGERÄT**
ELECTRONIC BRANCH SWITCHING DEVICE
APPAREIL DE COMMUTATION ELECTRONIQUE DE DERIVATION

(30) Priorität: 27.03.1996 DE 19612216
(43) Veröffentlichungstag der Anmeldung: 13.01.1999
(73) Patentinhaber: SIEMENS AKTIENGESELLSCHAFT, 80333 München (DE)
(72) Erfinder: KALUZA, Peter, D-92266 Ensdorf (DE); MAIER, Reinhard, D-91074 Herzogenaurach (DE); MITLEHNER, Heinz, D-91080 Uttenreuth (DE); SCHRECKINGER, Christian, D-93444 Kötzting (DE); SCHRÖTHER, Gerhard, D-92224 Amberg (DE)
(86) Internationale Anmeldenummer: DE9700503
(87) Internationale Veröffentlichungsnummer: WO9736373

(56) Entgegenhaltungen:
- EP-A- 0 304 951
- EP-A- 0 654 904
- DE-A- 4 136 514
- GB-A- 2 138 229
- US-A- 4 493 002
- US-A- 4 691 263
- US-A- 4 924 343
- US-A- 4 924 344
- US-A- 5 006 949

## Beschreibung

Die Erfindung bezieht sich auf ein Abzweigschaltgerät.

Abzweige werden üblicherweise durch Hintereinanderschaltung verschiedener Schaltgeräte realisiert wie z.B. im Siemens-Handbuch "Schalten, Schützen, Verteilen in Niederspannungsnetzen" (Auflage 1992, Tabelle 3.17, S.143) dargestellt. Hier wird ein Motor unter Zwischenschaltung eines Leistungsschalters, eines Schützes und eines Überlastschutzes von einer Spannungsquelle elektrisch versorgt. Als weitere Schaltelemente und Komponenten zur Ansteuerung von Verbrauchern sind Drehstromsteller, Halbleiterrelais, Umrichter, mechanische Limiter, Motorschutzschalter und Schmelzsicherungen sowie indirekte Überlastrelais bekannt. Mit derartigen Niederspannungsabzweigen werden unterschiedliche Schaltvorgänge durchgeführt. Hierzu gehört das betriebsmäßige Schalten von Verbrauchern sowie das phasengesteuerte oder phasenanschnittgesteuerte Schalten von Motoren, Kondensatoren und nichtlinearen Verbrauchern wie z.B. Lampen und Drosseln. Bei letzteren erfolgt die Schaltung momentan, z.B. im Nulldurchgang oder zwischen den Nulldurchgängen. Kurzschlußströme im Abzweig werden zur Vermeidung schädigender Überlastungen in ihrer Höhe begrenzt. Eine weitere Funktion des Niederspannungsabzweigs besteht im Erkennen von Kurzschlußströmem und deren Abschaltung in kürzester Zeit unter Berücksichtigung der zulässigen Überspannung. Wünschenswert wäre es unter anderem auch, eine Aufschaltung von Verbrauchern auf Kurzschlüsse zu verhindern bzw. eine möglichst rasche Abschaltung zu erreichen, wenn trotzdem auf einen Kurzschluß aufgeschalten wird. Weiterhin werden in den Niederspannungsabzweigen Überlastfälle detektiert und erforderlichenfalls abgeschaltet. Zur Zustandsüberwachung werden die jeweiligen Betriebszustände des Abzweigs gemeldet.

Die EP 0 304 951 A2 offenbart ein elektronisches Abzweiggerät zur An- und Abschaltung einer Last an eine Stromversorgungsquelle, wobei zwei mit einer potentialfreien Ansteuereinrichtung angesteuerte, bidirektional geschaltete Halbleiterschaltelemente in Reihe zur Last geschaltet sind. Im Laststromkreis sind keine unterbrechenden Schaltgeräte mit Trennstrecken vorgesehen.

Aus der US 5,006,949 A1 ist eine Einrichtung bestehend aus einem Widerstand und Transistoren bekannt, mit der der Strom im Laststromkreis im Überlastfall abgeschaltet wird. Weiterhin ist hier eine als Optokoppler ausgeführte Ansteuerschaltung offenbart, die in der Lage ist, Steuersignale galvanisch getrennt an Halbleiterschaltelemente zu übertragen.

Die EP 0 421 891 B1 offenbart einen statischen Trennschalter mit galvanischer Trennung. Hier wird eine Last, der ein Halbleiter-Schaltelement vorgeschaltet ist, mit Gleichstrom versorgt. Das Halbleiter-Schaltelement schaltet den Strom im Normalzustand sowie bei Überlast und Kurzschlußzuständen aus. Für den Fall, daß das Halbleiter-Schaltelement versagt, wird der im Laststromkreis liegende Trennschalter geöffnet. Zur Auslösung dient hierbei ein parallel zur Last geschalteter Elektromagnet, über dessen Ankerstellung der Befehl zum Öffnen des Trenners erfolgt. Bei Versorgung der Last aus einer Wechselspannungsquelle werden anstelle eines Halbleiter-Schaltelements zwei bidirektional geschaltete Transistoren verwendet.

Aus der DE 42 09 167 Al ist eine Schalt- und Überwachungseinheit für elektrische Antriebe bekannt. Die Einheit dient insbesondere zur Schaltung und Überwachung von elektrischen Antrieben mit Betriebsspannungen über 60 V, insbesondere für Hilfs- und Nebenantriebe, wobei die elektrischen Antriebe Schaltelemente, z.B. Leistungsschaltelemente, Schutzschaltungselemente und Stromrichter aufweisen. Anstelle mechanischer Schalter, z.B. Trennschalter und Motorschutzschalter, werden hier Halbleiter-Schaltelemente zum Schalten vorgeschaltet, bei denen sich im Betrieb einstellende IST-Zustände abgegriffen und Überwachungselementen bzw. Schaltungen aufgegeben werden.

Der Erfindung liegt die Aufgabe zugrunde, ein Abzweigschaltgerät zu schaffen, mit dem elektronisch die bei Abzweigen bekannten Funktionen zur An- und Abschaltung einer Last im Normalbetrieb und im gestörten Betrieb (Überlast, Kurzschluß) auf einfache Weise, insbesondere unter Einhaltung der zulässigen Überspannungen, erfolgt.

Die Aufgabe wird gelöst durch ein elektronisches Abzweigschaltgerät mit den Merkmalen nach Anspruch 1.

Weitere vorteilhafte Ausbildungen der Erfindung sind den Unteransprüchen 2 bis 4 zu entnehmen.

Zwei Ausführungsbeispiele der Erfindung werden im Folgenden anhand einer Zeichnung näher erläutert. Es zeigen:
- FIG 1: eine erste Schaltung für ein elektronisches Abzweigschaltgerät und
- FIG 2: eine zweite Schaltung für ein elektronisches Abzweigschaltgerät gemäß der Erfindung.

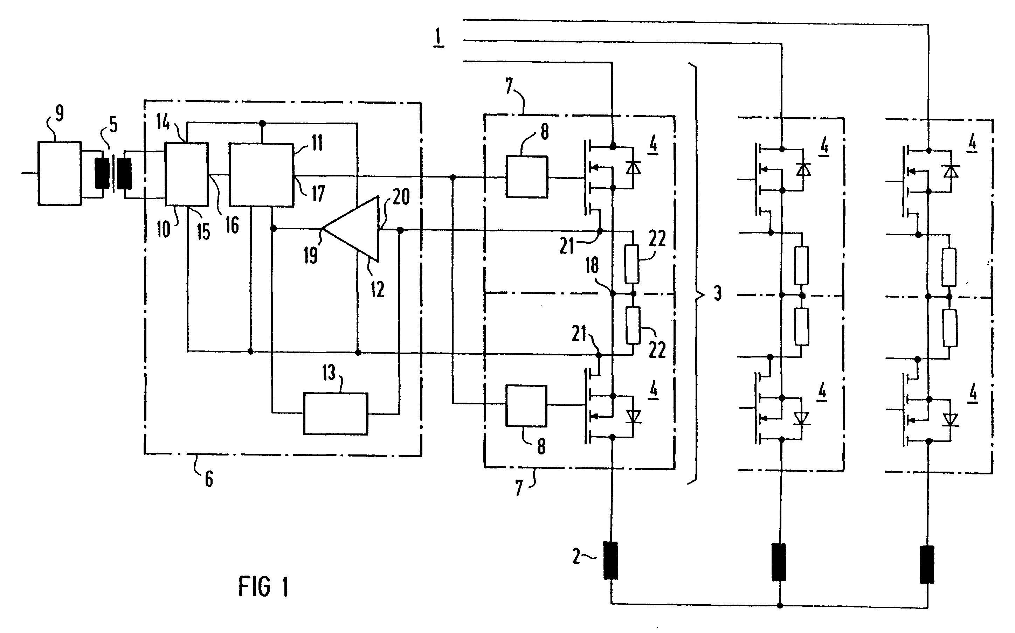

Gemäß FIG 1 ist zwischen ein Drehstromnetz 1 und eine dreiphasige Last 2 ein dreiphasiges elektronisches Abzweigschaltgerät 3 geschaltet, über das die Last 2, z.B. ein Motor, mit Strom versorgt werden kann. Das elektronische Abzweigschaltgerät 3 ist in den drei Phasen gleich aufgebaut, weswegen hier vereinfachend der Aufbau nur für eine Phase zeichnerisch dargestellt ist. Das elektronische Abzweigschaltgerät 3 enthält im wesentlichen zwei bidirektional geschaltete und in Reihe zur Last 2 liegende Halbleiter-Schaltelemente 4, eine potentialfreie Ansteuerungseinrichtung 5 und eine zwischen diese und die Halbleiter-Schaltelemente 4 geschaltete Ansteuerschaltung 6. Die Halbleiter-Schaltelemente 4 sind hier FETs, die jeweils z.B. vorteilhaft auf einem dem HITFET-Baustein entsprechenden, aber für wesentlich höhere Spannungen ausgelegtem Baustein 7, der ebenfalls eine als Schutzschaltung 8 ausgeführte Logik enthält, realisiert sind. Nähere Angaben zum Aufbau und der Funktion der HITFET-Bausteine sind der Veröffentlichung "HITFET-Low-Side-Schalter für alle Fälle" in der Fachzeitschrift Components 33 (1995), Heft 2, Seite 59ff, zu entnehmen. Die potentialfreie Ansteuereinrichtung ist hier als Übertrager 5 ausgeführt, auf dessen Primärseite eine Treiber-/Modulatorschaltung 9 angeschaltet ist, die z.B. durch den Baustein UC3724 der Firma Unitrode Intigrated Circuits realisiert sein kann. Die Ansteuerschaltung 6 besteht im wesentlichen aus einem weiteren Treiberbaustein 14, z.B. UC3725 von Unitrode, einem Flip-Flop 11, einem Komparator 12 und einer Überlasterkennungseinrichtung 13. Eine Treiber-/Demodulatorschaltung 10 ist an die Sekundärseite des Übertragers 5 angeschlossen und über ihre Anschlüsse 14 und 15 mit einem Komparator 12 und mit einem Flip-Flop 11 verbunden. Ein weiterer Anschluß 16 der Treiber-/Modulatorschaltung 10 ist mit dem Flip-Flop 11 verbunden, das ausgangsseitig über den Anschlußpunkt 17 an die Bausteine 7 geführt ist. Der Anschlußpunkt 15 des Bausteins 10 steht mit dem Verbindungspunkt 18 zwischen den Bausteinen 7 in elektrischer Verbindung. Das Flip-Flop 11 ist außerdem an den Ausgang 19 des Komparators 12 angeschlossen. Dessen Eingang 20 ist mit dem Anschlußpunkt 21 des ohmschen Widerstandes 22 verbunden. Der andere Anschlußpunkt des ohmschen Widerstandes 22 ist der Verbindungspunkt 18. Die Überlasterkennungseinrichtung 13 liegt zwischen dem Eingang 20 und dem Ausgang 19 des Komparators 12.

Im Folgenden wird die Funktion des Abzweigschaltgeräts 3 anhand der FIG 1 näher beschrieben:

Die beiden FETs 4 dienen zum Schalten des Laststromkreises bei Nennlast, Überlast und Kurzschluß. In jedem Baustein 7 ist mit dem internen Widerstand 22 und einer geteilten Source-Elektrode ein Bypass realisiert, mit dem der Laststrom gemessen werden kann. Mit Hilfe des Komparators 12, an dem eingangsseitig der Spannungsabfall über dem ohmschen Widerstand 22 ansteht, werden Nullströme bzw. unterhalb minimaler Stromschwellen liegende Lastströme detektiert. Bei Unterschreiten einer den Nullstrom darstellenden minimalen Stromschwelle bildet das Flip-Flop 11 ein Abschaltsignal, mit dem die FETs 4 unverzüglich in Nulldurchgang abgeschaltet werden, was zur Abschaltung induktiver Lasten unerläßlich ist. Die im Baustein 7 enthaltene Logik 8 bewirkt die Kurzschlußabschaltung bzw. Strombegrenzung. Die beiden Bausteine 9 und 10 bilden zusammen mit dem Übertrager 5 eine potentialfreie Ansteuerung sowie die Stromversorgung für das Flip-Flop 11, für den Komparator 12 und für die Überlasterkennungseinrichtung 13. Die Überlasterkennungseinrichtung 13 bildet aus dem Stromsignal und der zeitlichen Belastung nach Überschreiten eines Schwellwertes ebenfalls ein Auslösesignal.

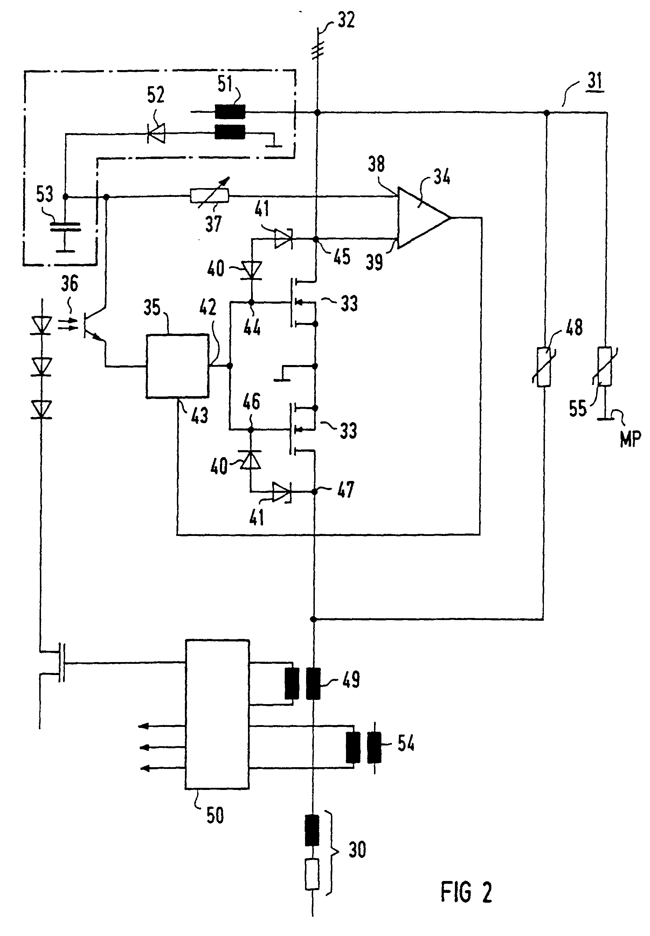

FIG 2 zeigt ein weiteres Ausführungsbeispiel der Stromversorgung einer Last 30 über ein Abzweigschaltgerät 31, wobei die Stromversorgung über eine dreiphasige Spannungsquelle 32 erfolgt. Das Abzweigschaltgerät 31 ist hier ebenfalls nur einphasig dargestellt und umfaßt im wesentlichen zwei bidirektional geschaltete und in Reihe zur Last 30 liegende FET-Transistoren 33, einen Komparator 34, ein Flip-Flop 35 und einen Optokoppler 36. Der Optokoppler 36 ist einerseits an den Pluspol eines Gleichspannungs-Netzteils geschaltet, das gestrichelt in FIG 2 angedeutet ist und aus einem Transformator 51, einer Diode 52 und einem Kondensator 53 besteht. Ein ebenfalls am Pluspol liegender verstellbarer ohmscher Widerstand 37 ist mit dem Eingang 38 des Komparators 34 verbunden, an dessen anderen Eingang 39 der Drain-Anschluß 45 des einen FET-Transistors 33 angeschlossen ist. Andererseits ist der Optokoppler 36 mit dem Flip-Flop 35 verbunden, dessen einer Ausgang 42 zur Ansteuerung an die Gate-Anschlüsse 44 bzw. 46 der FET-Transistoren 33 geführt ist. Der andere Ausgang 43 des Flip-Flops 35 ist mit dem Ausgang des Komparators 34 elektrisch verbunden. Zwei entgegengesetzt gepolte Dioden 40,41 liegen jeweils zwischen den Gate-Anschlüssen 44 bzw. 46 und den Drain-Anschlüssen 45 bzw. 47 der FET-Transistoren 33. Zwischen den Drain-Anschlüssen 45 und 47 liegt ein Varistor 48. Zwischen der Last 30 und dem Drain-Anschluß 47 liegt die Primärwicklung eines Stromwandlers 49, dessen Sekundärwicklung an einen Auswertungsbaustein 50 angeschlossen ist. An diesen ist in Aron-Schaltung ein weiterer Stromwandler 54 angeschlossen. Ein weiterer Varistor 55 ist zwischen einer Phase der Drehstrom-Versorgung 32 für die Last 30 und deren Mittelpunkt MP geschaltet.

Die Funktion des Abzweigschaltgeräts gemäß FIG 2 wird im Folgenden näher erläutert.

Auch hier dienen wiederum die beiden FET-Transistoren 33 zum Schalten des Laststromkreises bei Nennlast, bei Überlast und Kurzschluß. Die Messung von Überlast- und Nennströmen erfolgt hier mittels der Drain-Source-Spannung des einen FET-Transistors 33, die an den Eingang 39 des Komparators 34 gerührt ist. Letzterer dient wie im vorherigen Ausführungsbeispiel zur Detektion von Nullströmen bzw. sehr niedrigen Strömen, was in Verbindung mit der Abschaltung induktiver Lasten unbedingt erforderlich ist. Die Beschaltung der beiden FET-Transistoren 33 mit den Dioden 40,41 dient zur Begrenzung des Kurzschlußstromes und stellt somit einen Schutz der FET-Transistoren 33 dar. Mit dem Optokoppler 36 wird die gesamte Schaltung des Abzweigschaltgeräts 31 potentialfrei angesteuert. Die Stromversorgung der gesamten Schaltung erfolgt dabei über das aus dem Transformator 51, der Diode 52 und dem Kondensator 53 bestehende Gleichspannungsnetzteil. Die beiden in Aronschaltung geschalteten Stromwandler 49 und 54 speisen den Überlastbaustein 50, dem beispielsweise ein Schwellwert für die Stromlast vorgegeben werden kann, bei der ein angeschlossener Motor zum Schutz gegen Überlast abgeschaltet wird. Der Auswertungsbaustein 50 ist bei am Markt befindlichen elektronischen Überlastrelais des Typs 3UB1 und 3RB1 der Firma Siemens bekannt. Die beiden Varistoren 48,55 bilden einen Überspannungsschutz für das Abzweigschaltgerät 31 gegen die Last 30 und gegen den Mittelpunkt MP.

Das elektronische Abzweigschaltgerät 31 weist insgesamt folgende Funktionen auf:
- Bei Überlast und Nennlast die Abschaltung im Stromnulldurchgang wegen der hohen Lastinduktivitäten.
- Sofortiges Abschalten und Begrenzungen des Stromes im Kurzschlußfall.
- Eine potentialfreie Ansteuerung.
- Einen Überlastschutz.

Obwohl die vorliegende Erfindung unter Bezugnahme auf die in der beigefügten Zeichnung dargestellte Ausführungsform erläutert ist, sollte berücksichtigt werden, daß damit nicht beabsichtigt ist, die Erfindung nur auf die dargestellte Ausführungsform zu beschränken, sondern alle möglichen Änderungen, Modifizierungen und äquivalente Anordnungen, soweit sie vom Inhalt der Patentansprüche gedeckt sind, einzuschließen.

## Patentansprüche

1. Elektronisches Abzweigschaltgerät (3,31) zur An- und Abschaltung einer Last (2,30) an eine Stromversorgungsquelle (1,32) mit folgenden Merkmalen:
a) mit zwei bidirektional geschalteten aus Silizium-Carbid als Substrat hergestellten Halbleiter-Schaltelementen (4,33) in Reihe zur Last (2,30),
b) mit einer potentialfreien Ansteuereinrichtung (5,9,10,36) zur Ansteuerung der Halbleiter-Schaltelemente (4,33), über die die Halbleiter-Schaltelemente (4,33) ein- und ausschaltbar sind,
c) mit einer Einrichtung (8,22,40,41) zur Sofortabschaltung eines über die Last fließenden Kurzschlußstroms und
d) mit einer Schutzeinrichtung (13,49,50) gegen Überlastströme im Laststromzweig,
e) wobei keine den Stromkreis der Last (2,30) unterbrechenden Schaltgeräte mit Trennstrecken vorgesehen sind und
f) mit einer Einrichtung (11,12,34,35) zur Stromnulldurchgangserkennung, die ein Abschaltsignal liefert, mit dem die Halbleiter-Schaltelemente (4,33) unverzüglich abschaltbar sind.

2. Elektronisches Abzweigschaltgerät nach Anspruch 1, **dadurch gekennzeichnet,** daß die Halbleiter-Schaltelemente (4,33) jeweils zusammen mit zu Schutzeinrichtungen zugehörigen Elementen (8,22) in einem integrierten Baustein (7) enthalten sind.

3. Elektronisches Abzweigschaltgerät nach Anspruch 1 oder 2, **dadurch gekennzeichnet,** daß zur Feststellung der Größe des Laststromes und seines Nulldurchgangs die Spannung an einem ohmschen Widerstand (22) abgegriffen wird, über den ein prozentual gleichbleibender Laststromanteil fließt, und die Spannung einem Komparator (12) zugeführt wird, der bei Unterschreiten seiner einstellbaren Schwellspannung eine Rücksetzung eines zur Ansteuerung der Halbleiter-Schaltelemente (4) vorgesehenen Flip-Flops (11) bewirkt und damit deren Abschaltung ermöglicht.

4. Elektronisches Abzweigschaltgerät nach einem der vorangehenden Ansprüche, **dadurch gekennzeichnet,** daß eine Messung der Größe des Laststroms mit Hilfe einer an einem der Halbleiter-Schaltelemente (33) abfallenden Spannung erfolgt, die am Eingang (39) eines Komparators (34) als Eingangsgröße ansteht, der im Zusammenwirken mit einem Flip-Flop (35) eine Abschaltung der Halbleiter -Schaltelemente (33) ermöglicht.

## Claims

1. Electronic branching device (3, 31) for connecting and disconnecting a load (2, 30) at a power supply source (1, 32) with the following features.
a) With two bi-directional semiconductor switching elements (4, 33) manufactured as a substrate from silicon carbide and connected in series with the load (2, 30).
b) With a potential-free control device (5, 9, 12, 36) for controlling the semiconductor switching elements (4, 33), by means of which the semiconductor switching elements (4, 33) can be switched on and off.
c) With a device (8, 22, 40, 41) for the immediate disconnection of a short-circuit current flowing through the load and
d) with a protective device (13, 49, 50) to protect against overcurrents in the load current branch,
e) whereby none of the switching devices for isolating the circuit of the load (2, 30) are provided with isolating paths and
f) with a device (11, 12, 34, 35) for detecting current zero-crossing, which supplies a disconnect signal by means of which the semiconductor switching element (4, 33) can be immediately shut down.

2. Electronic branching device according to claim 1, characterised in that the semiconductor switching elements (4, 33) are contained together with the elements (8, 22) of protective devices in an integrated module (7).

3. Electronic branching unit in accordance with claims 1 or 2, characterised in that to determine the magnitude of the load current and its zero-crossing the voltage is tapped off at an ohmic resistor (22) through which percentage constant load current content flows and the voltage is applied to a comparator (12) which, if its set threshold voltage is undershot, causes a flip-flop (11) designed to trigger the semiconductor switching elements (4) to be triggered and thus enables them to be switched off.

4. Electronic branching device in accordance with one of the preceding claims, characterised in that the magnitude of the load current is measured with the aid of a voltage reducing at one of the semiconductor switching elements (33), which is present at the input (39) of a comparator (34) as an input variable, which interacts with a flip-flop (35) to enable the semiconductor switching elements (33) to be switched off.

## Revendications

1. Appareil de commutation électronique de dérivation (3, 31) pour le branchement et le débranchement d'une charge (2, 30) à une source d'alimentation en courant (1, 32) avec les caractéristiques suivantes :
a) comprenant deux éléments de commutation à semi-conducteurs (4, 33) branchés de façon bidirectionnelle, fabriqués à partir de carbure de silicium comme substrat et branchés en série vers la charge (2, 30),
b) comprenant un dispositif de commande hors potentiel (5, 9, 10, 36) qui est destiné à la commande des éléments de commutation à semi-conducteurs (4, 33) et par l'intermédiaire duquel les éléments de commutation à semi-conducteurs (4, 33) peuvent être branchés et débranchés,
c) comprenant un dispositif (8, 22, 40, 41) pour la coupure immédiate d'un courant de court-circuit passant par la charge et
d) comprenant un dispositif de protection (13, 49, 50) contre des courants de surcharge dans la branche de courant de charge,
e) dans lequel il n'est prévu aucun appareil de commutation interrompant le circuit de courant de la charge (2, 30) et comportant des espaces intercontacts et
f) comprenant un dispositif (11, 12, 34, 35) qui est destiné à la détection de passage par zéro du courant et qui délivre un signal de coupure avec lequel les éléments de commutation à semi-conducteurs (4, 33) peuvent être coupés sans retard.

2. Appareil de commutation électronique de dérivation selon la revendication 1, caractérisé par le fait que les éléments de commutation à semi-conducteurs (4, 33) conjointement à des éléments (8, 22) appartenant à des dispositifs de protection sont contenus dans un composant intégré (7).

3. Appareil de commutation électronique de dérivation selon la revendication 1 ou 2, caractérisé par le fait que, pour déterminer la grandeur du courant de charge et son passage par zéro, la tension est prélevée à une résistance ohmique (22) par laquelle passe une part de courant de charge restant identique en pourcentage et la tension est envoyée à un comparateur (12) qui, lorsque la tension est inférieure à sa tension de seuil réglable, provoque une remise à zéro d'une bascule bistable (11) prévue pour la commande des éléments de commutation à semi-conducteurs (4) et permet ainsi leur coupure.

4. Appareil de commutation électronique de dérivation selon l'une des revendications précédentes, caractérisé par le fait qu'une mesure de la grandeur du courant de charge s'effectue à l'aide d'une tension qui chute à l'un des éléments de commutation à semi-conducteurs (33) et qui est présente comme grandeur d'entrée à l'entrée (39) d'un comparateur (34) qui permet en coopération avec une bascule bistable (35) une coupure des éléments de commutation à semi-conducteurs (33).
